# EUROPEAN PATENT APPLICATION

(11) **EP 2 846 364 A1**
(43) Date of publication of application: **11.03.2015**
(21) Application number: 14183250.1
(22) Date of filing: 02.09.2014
(51) Int. Cl.: H01L 31/18, G01R 31/40

(54) **Method to decimate the samples necessary to identify one characteristic curve of at least one power supply modul and computer program for associated distributor**

(30) Priority: 05.09.2013 IT TO20130717
(71) Applicant: BITRON S.p.A., 10122 Torino (IT)
(72) Inventor: Carotenuto Pietro Luigi, I-84084 Fisciano (SA) (IT); Manganiello, Patrizio, I-84084 Fisciano (SA) (IT); Petrone, Giovanni, I-84084 Fisciano (SA) (IT); Spagnuolo, Giovanni, I-84084 Fisciano (SA) (IT); Vitelli, Massimo, I-84084 Fisciano (SA) (IT); Cirillo, Luigi, I-10095 Grugliasco (TO) (IT); Cullino, Carlo, I-10095 Grugliasco (TO) (IT)
(74) Representative: Vitillo, Giuseppe

(57) **Abstract**

A method to decimate the number of samples (S) that are necessary to identify a characteristic curve of a power supply module.

Said module is adapted to operate in a field of a first characteristic parameter of said module and a field of a second characteristic parameter of said module.

The method comprises the following steps:
• dividing the field of a first parameter and the field of a second parameter into a plurality of intervals;
• determining, for each second interval (ΔV) of said second parameter, a first number (N1) of first intervals (ΔI) of said first parameter covered by the samples (S) comprised in the single second interval (ΔV);
• determining, for each first interval (ΔI) of said second parameter, a second number (N2) of second intervals (ΔV) of said second parameter covered by the samples (S) comprised in the single first interval (ΔI);
• for each single sample (S), comparing the corresponding first number (N1) and the corresponding second number (N2);
• identifying one or more samples (S), for which the comparison between the corresponding first number (N1) and the corresponding second number (N2) has a variation;
• for each sample identified in the previous step, starting from that sample, determining a first sample interval (ΔK) wherein at least one fundamental point of the characteristic curve lies;
• storing in a memory medium only the samples (S) comprised in each first value interval (ΔK) determined in the previous step.

## Description

The present invention relates to a method, implementing a specific algorithm, to decimate or select a reduced number of samples that are necessary to describe the development of a characteristic curve of at least one power supply module, starting from a series of samples obtained by means of measurements or by means of simulations.

The power supply module could be at least a photovoltaic cell, a photovoltaic module or photovoltaic panel or a string or a series of strings connected in parallel, whose characteristic curve is, for example, the voltage-current curve and/or the power-voltage curve. For the purpose of the present invention, the term "module" describes, without distinctions, a single photovoltaic cell, a single photovoltaic module, a plurality of modules creating a panel, a plurality of modules creating a string, and a plurality of strings creating a photovoltaic system.

A further power supply module, equivalent to the one described above, could be a battery or a battery pack, whose characteristic curve is, for example, the voltage-current curve of each single battery or cell. For the purpose of the present invention, the term "module" describes, without distinctions, a single battery module, a plurality of modules creating a battery, a plurality of batteries creating a battery pack, and a plurality of battery packs creating an energy storage system.

Another type of power supply module, equivalent to the ones described above, could be at least one fuel cell or fuel battery, whose characteristic curve is, for example, the voltage-current curve of each single cell or battery. For the purpose of the present invention, the term "cell" describes, without distinctions, both a single fuel cell and a plurality of cells creating a power supply system.

The present invention, given a plurality of measure samples of a specific characteristic curve of a power supply module, allows the selection of a reduced number of samples, which permit the reconstruction of the curve with a very small relative error.

The present invention allows users to select only the sample provided with a large quantity of information, thus leaving out the samples provided with a small quantity of information, with reference to the theory of the quantity of information.

Furthermore, the present invention relates to a computer program, which is adapted to carry out the method according to the present invention.

The method according to the present invention can be used in a possible technical field, which is descriptive and non-limiting, such as the photovoltaic field, in which users have to know some characteristic parameters of a photovoltaic cell, a photovoltaic panel or a panel string, such as for example voltage and current, so as to identify a voltage-current curve and/or a power-voltage curve. The parameters, such as voltage and current, are obtained by means of sampling.

The method according to the present invention can be applied, in an equivalent fashion, in other technical fields, such as in the field of batteries or battery packs and/or in the field of fuel cells or cell batteries.

In the prior art, the aforesaid parameters, e.g. voltage and current, are normally used for purposes such as the reconfiguration of the string, in order to obtain the maximum power production, or for diagnosis purposes, in order to determine a fault in one or more panels, for example arranged inside a string. These data can be also used for prognosis purposes, in order to evaluate the correct operation of the system.

A person skilled in the photovoltaic art knows, with reference to a cell, a module or a panel or a string of panels properly coupled to one another, the possible developments of a current-voltage curve and of a power-voltage curve as a function of the level or irradiation, of the architecture with which the different modules of a panel are connected to one anther, of the number of bypass diodes and of the general environmental conditions. In the photovoltaic environment, for the purpose of the present invention, the term "uniform conditions of a panel or of a photovoltaic string" identifies a string or a panel in which the modules making up the panel or the string are in operating conditions that are substantially similar to one another, for example irradiation, temperature, inclination conditions, etc. that are uniform.

For the purpose of the present invention, the term "non-uniform conditions of a panel or of a string" identifies a string or a panel in which the modules making up the panel or the string are in operating conditions that are different from one another, for example irradiation, temperature, inclination conditions, etc. that are non-uniform.

Furthermore, in the photovoltaic environment, a skilled person knows that a curvature point or knee point of the current-voltage curve corresponds to a maximum or minimum point of the power-voltage function.

For the purpose of the present description, the term "curvature point or knee point" indicates a point of the curve in which there is a change from a substantially horizontal area, with a small inclination, to a substantially vertical area, with a great inclination, and vice versa. In particular, there can be curvature points with a concavity facing downwards, which are obtained with the change from a small-inclination section to a great-inclination section, and curvature or knee points with a concavity facing upwards, which are obtained with the change from a great-inclination section to a small-inclination section, as the parameter in the abscissa increases.

A person skilled in the photovoltaic environment also knows that, in case of a string or panel operating in non-uniform conditions, in order to determine the characteristics of the curve, such as the knee points, he/she has to collect a large number of samples, with the highest resolution possible, so as to characterize the curve in best possible way and so as to detect possible knee points, peaks and flexes of a curve in a very accurate manner.

In the prior art, in all the application fields of the method according to the present invention mentioned above, the number of samples measured for the characterization of the curve of a module, being very large, requires a large memory allocation, thus causing the project of a processing system for these sample to have great storing abilities and a high calculation speed, so as to extract at least the data that are deemed to be crucial for the curve and hence progressively free the memory occupied by the samples.

As a matter of fact, in the prior art, the samples deriving from a sampling step are normally overwritten on the samples stored during the previous sampling step, thus not allowing a processing of the data in retrospect. Indeed, the processing of these samples, in order to obtain information of the single module, normally has to be carried out in real time.

In the methods implemented in the prior art, in case of a remote processing of these samples, users have to design a high-speed communication line for the transmission of the data so as to allow all the samples to be transmitted and processed in short times. The costs for the electric power storage or generation system become high even due to the costs for the transmission line.

In the methods of the prior art, in any of the application fields mentioned above, the collection of samples for the characterization of the aforesaid curve is carried out at regular time intervals by using different measurement procedures, such as for example constant current interval procedures, constant voltage interval procedures, etc., as a function of the parameters defining the characteristic curve.

In the methods implemented in the prior art, in any application field of the method, subsequent to the collection of the samples, for example by means of properly designed measurement circuits, a local or remote processing unit processes the data so as to determine, for example, the interconnection configuration of the single power supply modules.

In general, it should be pointed out that many of the samples normally collected in the different applications mentioned above are provided with a quantity of information, able to characterize the curve, that is substantially equal to zero. Normally, the samples provided with a quantity of information substantially equal to zero, according to the mathematical theory of information, describe the segments of the curve having inclination that is substantially equal to zero or the segments of the curve having a great inclination. In the photovoltaic field, the samples provided with a quantity of information substantially equal to zero are the samples comprised in the segments with a constant current or voltage, or close to the open-circuit voltage point and to the closed-circuit current point. Specifically, in the photovoltaic field, the segments with a small quantity of information, in case of a single module, are the segments of the curve with a constant current or voltage, or the ones close to the open-circuit voltage point and to the closed-circuit current point; in case of a panel or string, each further pair of segments with a constant voltage and then current is caused by the activation of the bypass diodes for the protection of the single photovoltaic modules making up a panel in the presence of non-uniform operating conditions.

In the prior art, in all the application fields mentioned above, since there is no way to evaluate beforehand which samples are important and which are not, in order to obtain the necessary information on the operation of the power supply module, such a photovoltaic module, a battery module or a fuel cell, the processing unit processes all the samples collected. Therefore, the processing unit must have great calculation abilities and be very quick at carrying out the single calculations, performing difficult calculation operations even on samples that turn out to be irrelevant to determine the correct operation of the single power supply module.

In all the systems manufactured according to the prior art, the acquisition of more detailed information on the single modules takes place by means of dedicated electronic circuits, which are especially designed for the purpose and are added to the normal sampling devices mentioned above.

The sampling theorem establishes that the resolution with which samples should be collected must be as high as possible, so as to prevent some areas of whatever characteristic curve from being scarcely sampled and, therefore, hardly characterizable. The higher the resolution, the larger the number of samples to be collected and, therefore, the greater the memory space allocated and the greater the calculation power needed to examine all the samples, for example in case the samples are examined in real time. This aspect is a critical point in the different applications of the prior art.

Furthermore, one cannot establish beforehand which portion of curve is the one that contains the critical points of a characteristic curve of a power supply module, since they vary, especially as the operating conditions vary. An explanatory example is clearly offered by the photovoltaic field, in which a panel or a string, in non-uniform operating conditions, causes a significant variation of the curve relative to the ideal development of the voltage-current curve.

For the other types of power supply modules, operators need to be able to identify a special characteristic curve with a reduced number of samples, so as to solve the same technical problems discussed for the explanatory case of the photovoltaic module. Indeed, even for the single module of a battery or a battery pack, operators need to reduce the number of samples needed to properly characterize the battery or the battery pack.

Similarly, even for the power supply module in the form of a fuel cell, operators need to reduce the number of samples for the identification of the characteristic curve, so as to solve substantially similar technical problems applied to the specific technological field.

The object of the present invention is to solve the aforesaid technical problems by means of a method to decimate samples, which is able to store only the samples provided with a large quantity of information, thus eliminating the samples provided with a small quantity of information.

An aspect of the present invention relates to a method to decimate samples according to independent claim 1.

A further aspect of the present invention relates to a computer program having the features set forth in appended claim 18.

The accessory features of this method and/or of this computer program are set forth in the dependent claims.

The features and advantages of the method and the computer program according to the present invention will be best understood upon perusal of the following description thereof, for explanatory and non-limiting purposes applied to the photovoltaic field, with reference to the accompanying drawings, which respectively show what follows:

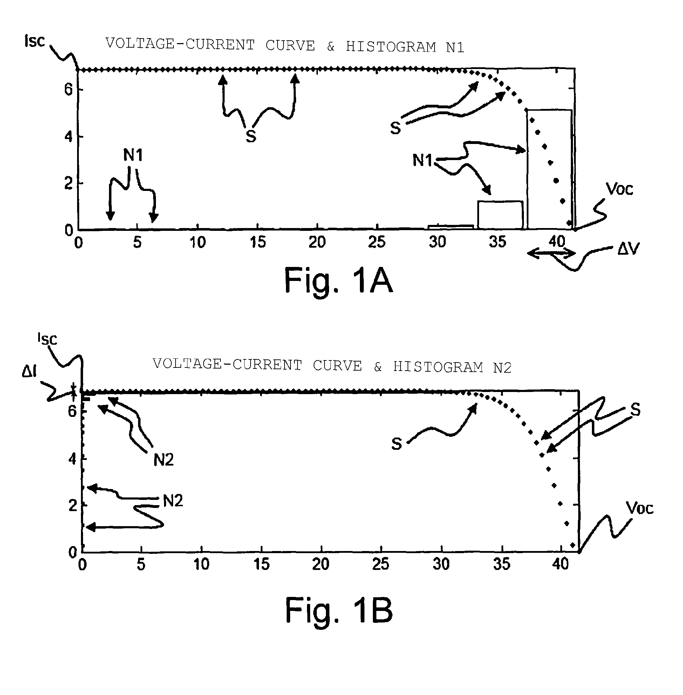

- figures 1A and 1B show an explanatory voltage-current curve of at least one power supply module, in particular of a photovoltaic module operating in uniform conditions, obtained by means of a sampling process, on which there is superimposed, respectively, a representation by means of histogram of the number of intervals of a parameter comprised in each interval of the complementary parameter, in particular figure 1A shows the sampled voltage-current curve and a histogram concerning a first number of current intervals comprised in each single voltage interval, figure 1B shows the sampled voltage-current curve and a histogram concerning a second number of voltage intervals comprised in each single current interval;

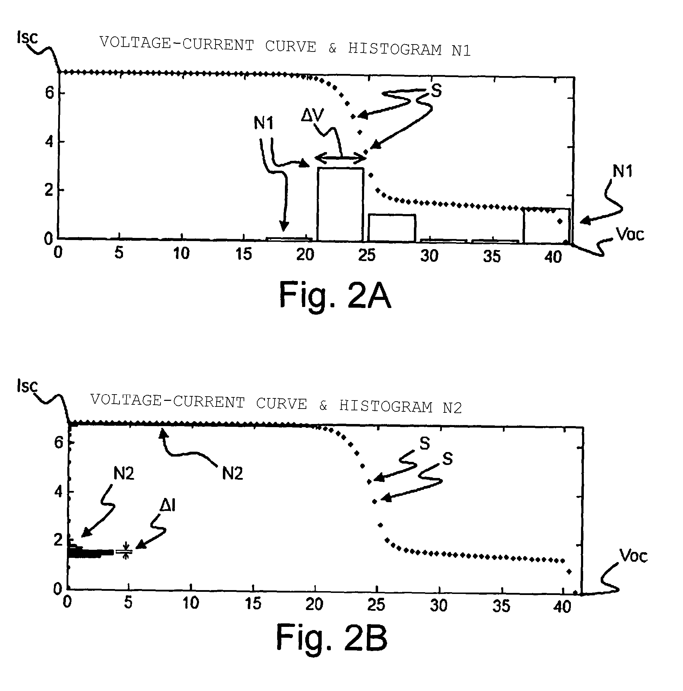

- figures 2A and 2B show an explanatory sampled voltage-current curve of at least one power supply module, in particular of a photovoltaic module operating in non-uniform conditions, on which there is superimposed, respectively, a representation by means of histogram of the number of intervals of a parameter comprised in each interval of the complementary parameter, in particular figure 2A shows the sampled voltage-current curve and a histogram concerning a first number of current intervals comprised in each single voltage interval, figure 2B shows the sampled voltage-current curve and a histogram concerning a second number of voltage intervals comprised in each single current interval;

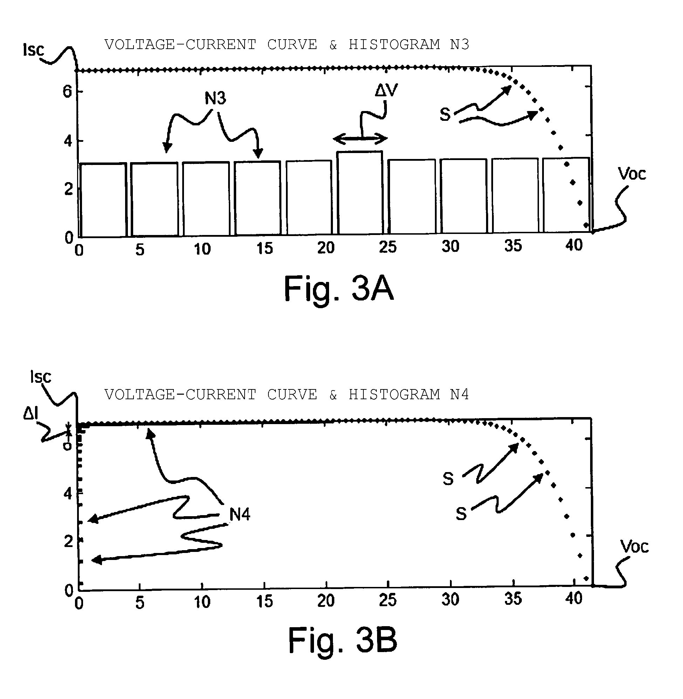

- figures 3A and 3B show an explanatory sampled voltage-current curve of at least one power supply module, in particular a photovoltaic module operating in uniform conditions, on which there is superimposed, respectively, a representation by means of histogram of the number of samples comprised in each interval, in particular figure 3A shows the sampled voltage-current curve and a histogram concerning a third number of samples comprised in each single voltage interval, figure 3B shows the sampled voltage-current curve and a histogram concerning a fourth number of samples comprised in each single current interval;

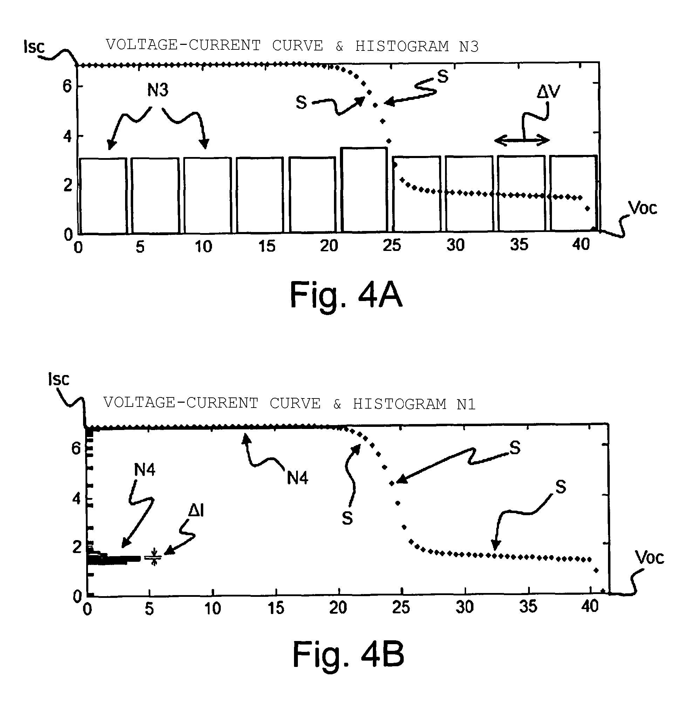

- figures 4A and 4B show an explanatory sampled voltage-current curve of at least one power supply module, in particular of a photovoltaic module operating in non-uniform conditions, on which there is superimposed a representation by means of histogram of the number of samples comprised in each interval, in particular figure 4A shows the sampled voltage-current curve and a histogram concerning a third number of samples comprised in each single voltage interval, figure 4B shows the sampled voltage-current curve and a histogram concerning a fourth number of samples comprised in each single current interval;

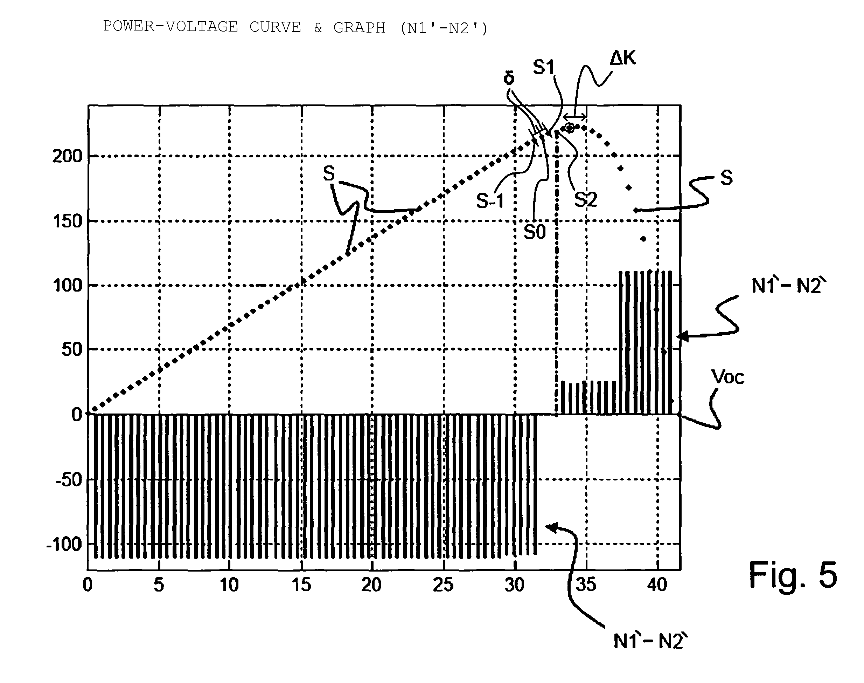

- figure 5 shows an explanatory power-voltage curve, which has been sampled or results from the processing of the samples for the voltage-current curve of at least one power supply module, in particular of a photovoltaic module operating in uniform conditions, on which there is superimposed a line graph representing the comparison, and in particular the difference, between the respective first number and the respective second number, associated with the respective intervals in which the single sample lies, in which one can see one single variation and, in particular, one single sign change of this difference;

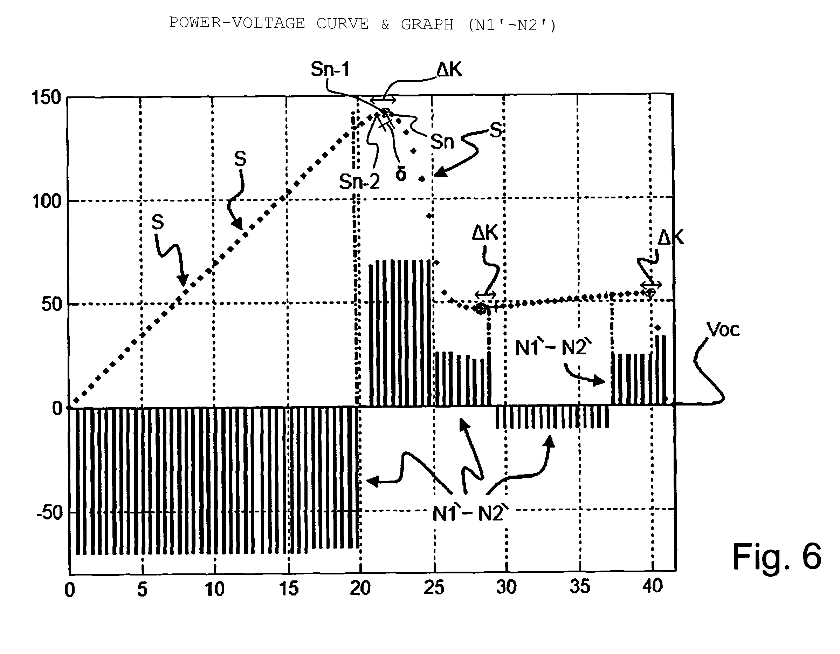

- figure 6 shows an explanatory power-voltage curve, which has been sampled or results from the processing of the samples of the voltage-current curve of at least one power supply module, in particular of a photovoltaic module operating in non-uniform conditions, on which there is superimposed a line graph representing the comparison, and in particular the difference, between the respective first number and the respective second number, associated with the respective intervals in which the single sample lies, in which one can see more than one variation and, in particular, more than one sign change of this difference;

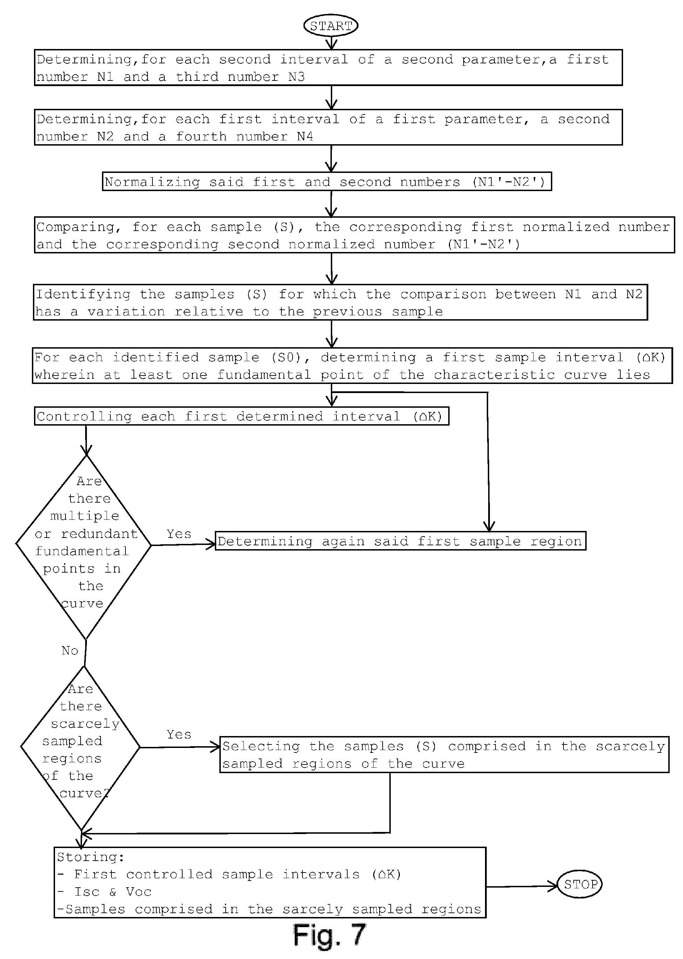

- figure 7 shows a possible flowchart, in which one can see the preferred sequence of steps of the method and of the program according to the present invention.

With reference to the figures mentioned above, the method to decimate or reduce the number of samples "S" of at least one parameter, for example an electric quantity, that are necessary to identify or reconstruct or characterize at least one characteristic curve of at least one power supply module, such as for example a photovoltaic module or a battery module or a fuel cell, is based on a series of samples "S" of a first parameter and a second parameter, such as for example voltage and current, which are obtained from measurements or simulations performed on said at least one power supply module. In general, said samples "S" can be linked, besides to current and/or voltage, to any other parameter concerning a physical quantity that can be measured, such as to be able to characterize any power supply module to be analyzed.

The characteristic curve can be obtained from a power supply module, such as for example a photovoltaic cell or module or a solar panel, or a battery or a fuel cell, or from a plurality of power supply modules that are properly connected to one another, such as for example a panel or a string of panels, a battery pack or a plurality of fuel cells. Therefore, the method according to the present invention is able to decimate, in an equivalent manner, the samples obtained, for example, both from a single power supply module and from a plurality of power supply modules that are properly connected to one another.

Said characteristic curve is defined by at least two intrinsic parameters of the power supply module, in particular by at least said first parameter and by at least said second parameter.

Said power supply module is adapted to operate in a field of a first characteristic parameter of said module and a field of a second characteristic parameter of the module itself.

Preferably, said first parameter and said second parameter are current and voltage, respectively. Therefore, the power supply module is adapted to operate in a current field raging from 0A to the value of the short-circuit current "Isc" at the ends of said at least one power supply module; and in a voltage field ranging from 0V to the value of the open-circuit voltage "Voc" at the ends of said at least one power supply module.

The characteristic curve for a photovoltaic module is defined by current and voltage, which are intrinsic parameters of the photovoltaic module.

Similarly, for the other application fields of the method according to the present invention, the characteristic curve is preferably defined by current and voltage, which are intrinsic parameters both of the battery module and of the fuel cell.

The method according to the present invention comprises the following steps:
- dividing the field of a first parameter and the field of a second parameter into a plurality of intervals, first intervals "ΔI" and second intervals "ΔV" respectively, with an assigned range;
- determining, for each second interval "ΔV" of said second parameter, a first number "N1" of first intervals "ΔI" of said first parameter covered by the samples "S" comprised in the single second interval "ΔV";
- determining, for each first interval "ΔI" of said first parameter, a second number "N2" of second intervals "ΔV" of said first parameter covered by the samples "S" comprised in the single first interval "ΔI";
- for each single sample "S", comparing the corresponding first number "N1" and the corresponding second number "N2" associated with the respective intervals (ΔV; ΔI) in which the sample "S" lies;
- identifying one or more samples "S", for which the comparison between the corresponding first number "N1"

and the corresponding second number "N2" has a variation relative to the previous sample;
- for each sample identified in the previous step, starting from that sample, determining a first sample interval "ΔK" wherein at least one fundamental point of the characteristic curve lies;
- storing in memory means only the samples "S" comprised in each first value interval "ΔK" determined in the previous step, for example so as to allow them to be processed.

For explanatory and non-limiting purposes, in the aforesaid steps of the method applied to the case of a voltage-current curve, said first parameter is the current and said second parameter is the voltage, which will use the same alphanumeric references, so as to make it easier for readers to understand the text, though without being a limitation thereto.

The method, in the specific embodiment, comprises the following steps:
- dividing the current field and the voltage field into a plurality of intervals, current intervals "ΔI" with an assigned range and voltage intervals "ΔV" with an assigned range, respectively;
- determining, for each voltage interval "ΔV", a first number "N1" of current intervals "ΔI" covered by the samples "S" comprised in the single voltage interval "ΔV";
- determining, for each current interval "ΔI", a second number "N2" of voltage intervals "ΔV" covered by the samples "S" comprised in the single current interval "ΔI";
- for each single sample "S", comparing the corresponding first number "N1" and the corresponding second number "N2" associated with the respective intervals (ΔV; ΔI) in which the sample "S" lies;
- identifying one or more samples "S", for which the comparison between the corresponding first number "N1" and the corresponding second number "N2" has a variation relative to the previous sample;
- for each sample identified in the previous step, starting from that sample, determining a first sample interval "ΔK" wherein at least one fundamental point of the characteristic curve lies;
- storing in memory means only the samples "S" comprised in each first value interval "ΔK" determined in the previous step, so as to allow them to be processed.

Preferably, these steps are performed one after the other in the order indicated above.

Below you can find a detailed description of the method according to the present invention in an explanatory and non-limiting embodiment.

In the non-limiting embodiment shown in figures 1A, 1B, 2A, 2B, 3A, 3B, 4A and 4B, concerning a power supply module characterized by a voltage-current curve, such as for example a photovoltaic module, the samples provided with a large quantity of information for the characterization of the curve are the ones close to a point where there is a sudden variation in the inclination, such as for example knee point of the voltage-current curve corresponding to a maximum or minimum point of the power-voltage curve. Furthermore, a skilled person knows that consecutive samples of the curve characterized by current values that differ due to very small values relative to "Isc" or that differ due to very small voltage values relative to "Voc", namely in which the inclination of the curve, drawn in a plane in which the abscissa determines the voltage and the ordinate determines the current, is very small or very great, respectively, are provided with a quantity of information that is substantially equal to zero.

For the purpose of the present invention, the term "quantity of information of a sample" means the quantity of information that a sample intrinsically contains to determine a wider piece of information, such as the identification of a curve, according to the mathematical theory of information. In a curve or function, the points having a large quantity of information are maximum points, either absolute or relative, minimum points, either absolute or relative, inflection points, asymptotes, etc.

More in detail, assuming that we start from a known number of samples of said first and second parameters, which are such as to allow the characterization of a characteristic curve of at least one power supply module, such as for example the current-voltage curve of said at least one power supply module, one determines the extremes of the respective fields of the parameters chosen, which, in the case of a voltage-current curve, are both short-circuit current "Isc" and the open-circuit voltage "Voc" of said at least one module.

Preferably, in the case of a voltage-current curve, besides samples "S" stored according to the steps listed above, further samples are stored, namely samples "S" corresponding to the value of short-circuit current "Isc" and to the value of open-circuit voltage "Voc".

In general, with reference to the step of diving the field of a first parameter and of a second parameter into a plurality of intervals, for example into current intervals "ΔI" and voltage intervals "ΔV" known in the case of a voltage-current curve, said intervals (ΔI, ΔV) can have an extension that is proportional to the respective field of said first and second parameter. In general, said first interval and said second interval have, respectively, a width that is preferably equal to a multiple of the resolution value with which the collecting system has collected respective samples "S".

In case of an application in the photovoltaic field, said extensions of the intervals (ΔI, ΔV) can be chosen also based on the typical values of the series and parallel resistances of an electric model of a photovoltaic panel, which are known to a person skilled in the art.

For information, the total number of intervals into which the field of a first parameter and the field of a second parameter are divided, respectively, can be determined by dividing the maximum value of the respective field by the value of the of the respective interval and by subtracting one from the resulting quotient. In the specific case of a voltage-current curve, the number of current and voltage intervals is, respectively, for example, for the current n_{(I)}=(Isc/ΔI)-1 or n_{(I)}=(Isc/ΔI), and for the voltage n₍ᵥ₎ = (Voc/ΔV)-1.

A method to divide the fields of said first parameter and of said second parameters, such as for example voltage and current, comprises the step of dividing into intervals the respective fields starting, respectively, from the maximum value of said first field, for example the value of short-circuit current "Isc", and from the maximum value of said second field, for example the value of open-circuit voltage "Voc".

Afterwards, there is the step of determining, for each first interval "ΔI" of said first parameter, for example current, a second number "N2" of second intervals "ΔV" of said second parameter, for example voltage, covered by samples "S" comprised in the single first interval "ΔI"; and the step of determining, for each second interval "ΔV" of said second parameter, a first number "N1" of first intervals "ΔI" of said first parameter covered by samples "S" comprised in the single second interval "ΔV". Said two steps can be performed simultaneously and/or switched with one another in sequence, while the method is carried out, without changing the features of the method according to the present invention.

In general, during these two steps, for each interval of a parameter, one determines the number of intervals of the complementary parameter that are covered by the samples that fall within the interval of said parameter itself. Said first number "N1" and said second number "N2" for each corresponding interval are temporarily stored in memory means, preferably a volatile and rewritable one.

Figures 1A and 2B show, by way of example, histograms superimposed on the voltage-current curve of at least one power supply module, for example a photovoltaic module, wherein one can see, for each current interval "ΔI", the number "N2" of intervals "ΔV" in which samples "S" fall within current interval "ΔI" itself. This number "N2" is larger in those segments of the curve in which the current remains substantially constant as the voltage varies.

Similarly, for each voltage interval, one determines the number of current intervals that are covered by the samples that fall within the voltage interval itself. Figures 1B and 2B show, by way of example, histograms superimposed on the voltage-current curve of at least one power supply module, for example a photovoltaic module, wherein one can see, for each voltage interval "ΔV", the number "N1" of current intervals "ΔI" in which samples "S" fall within the voltage interval "ΔV" itself. This number "N1" is larger in those segments of the curve in which the voltage remains substantially constant as the current varies.

Figures 1A and 1B show, by way of example, a voltage-current curve of at least of power supply module, for example a photovoltaic module, from which said curve is obtained, operating in uniform conditions. This means that it has one single segment with a substantially constant current as the voltage varies, one single knee point, in particular a curvature point with a concavity facing downwards, and one single segment with a substantially constant voltage as the current varies. Said at least one power supply module, for example a photovoltaic module, has a characteristic voltage-power curve with one single maximum point, defined as single-mode curve. Figures 2A and 2B show, by way of example, a voltage-current curve of at least of power supply module, for example a photovoltaic module, operating in non-uniform conditions. This means that it has more than one segment with a substantially constant current as the voltage varies, more than one curvature point or knee point of the curve, and more than one segment with a substantially constant voltage as the current varies, in particular it has curvature or knee points with a concavity facing downwards and curvature or knee points with a concavity facing upwards. In the case shown in figures 2A and 2B, you can see two segments with a substantially constant current, two curvature points or knee points of the curve with a concavity facing downwards, and two segments with a substantially constant voltage, and a curvature or knee point with a concavity facing upwards, which is interposed between the two curvature points or knee points of the curve with a concavity facing downwards.

In the specific photovoltaic field, curvature or knee points with a concavity facing downwards can be at most as many as the number of bypass diodes comprised in the panel or string. Said at least one photovoltaic module has a characteristic voltage-power curve with a plurality of maximum points, defined as multi-mode curve. In general, as one can clearly assume from the explanatory embodiment shown, significant current variations with a substantially constant voltage occur not only close to the open-circuit voltage "Voc", but also in correspondence to one or more intermediate voltages, whose value depends on the intrinsic features of the single power supply module, such as for example a photovoltaic module. The same also applies to the segments of the curve where there are significant voltage variations with a substantially constant current.

Preferably, in order to determine said first number "N1" and said second number "N2" associated with each respective interval (ΔV; ΔI), one should also add possible intervals (ΔI; ΔV) that fall within a fictitious interval. Said fictitious interval has as extremes the last sample comprised in the (ΔV; ΔI) considered and the first sample "S" comprised in the first successive interval (ΔV; ΔI) that has at least one sample "S" that falls within it.

In this way one can automatically exclude all empty intervals (ΔV; ΔI), namely those intervals within which no sample "S" falls.

This analysis allows operators to also take into account those intervals with one single sample "S".

Analyzing the value of the numbers N1, N2 calculated for each interval, one can easily determine the samples that describe the fundamental points of the curve, for example curvature points or knee points, namely one can visually identify, in an easy manner, samples "S" provided with a large quantity of information.

By comparing a voltage-current graph with the corresponding power-voltage graph of the same power supply module, such as for example a photovoltaic module, one can point out that the voltage values corresponding to the curvature or knee points of the voltage-current curve correspond to the maximum points, either relative or absolute, of the power-voltage curve of said at least one power supply module.

Preferably, for example simultaneously to the steps of determining said first and second number N1, N2, or even subsequent to o prior to this steps, the following further steps are provided:
- determining, for each second interval "ΔV" of said second parameter, for example voltage, a third number "N3" of samples "S" comprised in the single second interval "ΔV";
- determining, for each first interval "ΔI" of said first parameter, for example current, a fourth number "N4" of samples "S" comprised in the single first interval "ΔI";
- determining the mean value of said third numbers (N3) and the mean value of said fourth numbers (N4) comprised in the intervals (ΔV; ΔI);
- determining the first intervals and the second intervals, in which the number N3 and/or N4 of samples is smaller than the mean value.

Even in this case, these steps relate to a method that can be applied for the reduction of samples "S" defining a characteristic curve of any power supply module. More in particular, it can be applied by using any parameter - in particular physical quantity - that is useful to define the characteristic curve of the power supply module.

Figures 3A, 3B, 4A and 4B show, by way of example, the comparison of the voltage-current curve of a power supply module, for example a photovoltaic module, in two different irradiation conditions, and the corresponding histogram of the third value "N3" and of the fourth value "N4".

After the determination of said first and second number N1, N2 for the respective intervals (ΔV, ΔI), one can move on to the step in which each single sample "S" is compared with the corresponding first number "N1" and the corresponding second number "N2" associated with the respective intervals (ΔV; ΔI) in which the single sample "S" lies.

Since the respective intervals are numerically different, namely the total number of the respective intervals (ΔI, ΔV) is different, the relative numbers "N1" and "N2" cannot be directly compared with one another. For this reason, during the step in which, for each single sample "S", said first number "N1" and said second number "N2" are compared, said comparison step comprises a first normalization step for said first number "N1" and said second number "N2".

If, while the method is being carried out, floating-point format numbers, also known as "float" numbers, are used, the normalization step is performed by normalizing said first number "N1" and said second number "N2" relative to the maximum value taken on by the respective first and second number N1, N2 among all the respective intervals (ΔV; ΔI).

If, while the method is being carried out, integer fixed-point numbers are used, which are normally returned by electronic devices such as microprocessors, microcontrollers, FPGA circuits, etc., for example comprised in the inverter or in other electronic devices comprised by way of example in a system, for example a photovoltaic system, the comparison step comprises an intermediate step in which said first numbers "N1" and said second numbers "N2" are multiplied by a respective known scale factor. After having multiplied said first and second numbers N1, N2 by the scale factor, the first number "N1" and the second number "N2" are normalized relative to the maximum value taken on by the respective first and second number N1, N2 among all the respective intervals (ΔV; ΔI). Said scale factor must be chosen so as not not exceed the maximum value that can be represented with the integer format of the digital datum, namely so as to avoid overflow. In the preferred embodiment, in case integer fixed-point numbers are used, said scale factor is equal to the maximum value taken on among the first values "N1" and the second value "N2", irrespective of whether they relate to the intervals concerning the first or the second parameter. From a graphic point of view, this means that a histogram, namely one of the two histograms representing said first numbers and said second numbers N1, N2, remains unaltered and does not change; only the histogram having a smaller variation range is properly scaled, thus obtaining said first numbers N1and said second numbers N2 with values that can be compared with one another.

Said intermediate step, involving the multiplication by a scale factor, can be performed even in the case of floating-point format numbers.

After the first normalization step, in which said first number "N1" and said second number "N2" are normalized as a function of the type of format with which samples "S" are stored, a step is performed, in which said first normalized number "N1'" and said second normalized number "N2'" are compared. In the preferred embodiment, said second step is a subtraction between the values of said first and second numbers N1,N2 normalized N1',N2', in particular N1'-N2', wherein said first normalized numbers "N1'" and said second normalized numbers "N2'" are positive or null, namely negative, values.

To sum up, the difference between said first normalized number "N1'" and said second normalized number "N2'" is calculated for each sample "S".

Optionally, the result of the comparison between the first and the second number N1, N2 is temporarily stored in a memory medium, so as to also permit a graphic analysis of the results.

The aforesaid comparison step could be carried out by performing arithmetic operations other than the one of the solution described above, without for this reason going beyond the scope of protection of the present invention. By way of explanatory and non-limiting example, a different comparison method can comprise, for example, the step of calculating the logarithm of the ratio between the first number "N1" and the second number "N2", as well as other arithmetic operations that allow operators to obtain a comparison between said first number "N1" and said second number "N2" for each sample "S".

Figures 5 and 6 show, in a bar chart, which is superimposed on a power-voltage curve of a power supply module, such as for example a photovoltaic module, the result of the single aforesaid differences for each sample "S".

In the bar charts shown in figures 5 and 6 one can clearly see the points in which the difference (N1'-N2') is equal to zero or has a sign change, in particular shifts from a segment in which the bars are comprised in the lower half-plane, relative to the abscissa, to a segment in which the bars are comprised in the upper half-plane, relative to the abscissa.

Analyzing figures 5 and 6 more in detail and comparing the power-voltage curve with said bar chart, one can see how the sign change of the difference between the normalized values N1', N2' takes place close to the maximum and minimum points of the power-voltage curve.

In general, with reference to a voltage-current curve, the values deriving from the comparison - in particular from the subtraction (N1'-N2') - and having a negative value correspond to the regions of the voltage-current curve in which the samples cover a very low region in the current field and a very wide region in the voltage field. Similarly, the values deriving from the comparison - in particular from the subtraction - and having a positive value correspond to the regions in which the samples cover a very wide region in the current field and a very small region in the voltage field.

After the step in which, for each single sample "S", the corresponding first number and the corresponding second number are compared, one can move on to the step of identifying one or more samples "S" of at least one parameter, for example voltage and/or current, for which the comparison between said first number "N1" and said second number "N2" has a variation relative to the previous sample.

Preferably, said variation corresponds to a sign change, resulting, for example, from the difference between said first normalized number "N1'" and said second normalized number "N2'", relative to the previous sample.

The sample identified in this step is a starting point from which one can begin to perform a local search for fundamental points or characteristic points of a characteristic curve of at least one power supply module, such as for example maximum points, minimum points, asymptotes, etc.

Preferably, the local search for points takes place by means of a perturbative algorithm, which, by means of recursive or iterative comparisons, is able to delimit a fundamental point of a characteristic curve, thus extrapolating a reduced number of samples "S".

After having identified a sample "S" for which the comparison between said first number "N1" and said second number "N2" has a variation relative to the previous sample, one can move on to the step in which, for each sample identified, starting from that sample, a first sample interval "ΔK", for example a voltage and/or current interval, is determined, wherein at least one fundamental point of the characteristic curve of at least one power supply module lies.

In the step in which, for each sample identified in the previous step, at least one sample, for example a current and/or voltage sample, is identified, in order to determine the extension of a first interval "ΔK", the following steps are provided:
- starting from an initial sample determined in the previous step, here defined as "S0", calculating the value of a third parameter, for example power, referring to said initial sample "S0" and temporarily storing said value of the third parameter, such as for example power;
- moving on to a first subsequent sample, here defined as "S1", consequence of a variation "δ" of at least one parameter between said first parameter or said second parameter, such as for example voltage or current,
- calculating the value of said third parameter, for example power, associated with said first subsequent sample "S1";
- comparing the value of said third parameter referring to said first subsequent sample "S1" with the value of the third parameter calculated for said initial sample "SO";
- moving on to a second subsequent sample "S2", consequence of a variation "δ" of at least one parameter, such as for example voltage or current;
- calculating the value of said third parameter, such as for example power, associated with said second subsequent sample "S2" and comparing said value of said third parameter with the value of said third parameter calculated for at least one sample (SO, S1) examined previously; this comparison allowing operators to establish which region of the curve, close to the sample S, contains the fundamental point searched;
- continuing to vary the sample, in region identified, until the value of the third parameter calculated for a generic subsequent sample "Sn" has a tone variation relative to the tone detected for the values of the third parameter calculated for at least two consecutive samples examined previously (Sn_₂ and Sn_₁).

Said variation "δ" can have both a positive value, thus increasing the value of at least one parameter referring to the sample, and a negative values, thus decreasing the value of at least one parameter referring to the sample.

Said variation "δ", as shown in figures 5 and 6, preferably corresponds to a variation of the parameter indicated in the abscissa. In an equivalent embodiment, the variation "δ" can also be a variation of the parameter indicated in the ordinate.

This variation "δ" can can be such as to permit a shift from an initial sample "S0" to the immediately subsequent one in the characteristic curve, where the variation "δ" corresponds, for example, to the sampling interval or skip. In an equivalent embodiment, said variation "δ" permits a shift from an initial sample "S0" to a non-adjacent one, wherein this variation is, for example, a multiple of the sampling interval or skip with which the samples were collected.

The method according to the present invention can comprise a sequence of steps to determine said first interval "ΔK", in which a variation "δ" with a positive value is initially provided, and a following sequence of steps, in which a variation "δ" with a negative value is provided, starting from the initial sample "S0" identified. In particular, after having determined said first subsequent sample, instead of moving on to the second subsequent sample, thus performing a further variation "δ" with a positive value, starting from said first subsequent sample "S1" towards "S2", one moves on to the sample "S-1", consequence of a variation "δ" with a negative value of a parameter, such as voltage or current, starting from said initial sample "S0".

Even for this sample "S-1", one calculates the value of said third parameter, for example power.

Subsequently, the values of said third parameter of the samples "S1" and "S-1" are compared with the power value calculated for the initial sample "S0".

The value of the power variation between the two samples "S1" and "S0" and/or "S-1" and "S0", separated by a variation "δ" of at least one parameter, such as current or voltage, determines, as a function of the fundamental point searched, for example on the power-voltage characteristic curve, both the region in which to look for the fundamental point and the sign of the variation "δ" of the parameter with which to look for the fundamental point, irrespective of whether it refers to the first or to the second parameter, such as current or voltage.

For the purpose of the present invention, the term "curve region" indicates the curve portion upstream or downstream of an initial sample "S0", for example relative of the abscissa, where to look for the fundamental point of the curve.

These preliminary steps allows operators to quickly determine the most appropriate sign of variation "δ" to determine the characteristic point of the characteristic curve of the power supply module, as a function of the type of the corresponding characteristic point.

Said first interval "ΔK" has an extension whose two extremes are: the sample "Sn", for which a variation of tone of the third parameter, for example the power calculated or measured, was detected, and the sample "Sn₋ₖ" corresponding to at least two previous sample variation steps, preferably two, relative to sample for which the tone variation was detected, irrespective of whether a variation "δ" with a positive or negative sign was used.

At least one fundamental point of the characteristic curve, preferably one single point, lies in said first interval "ΔK".

For the purpose of the present invention, the term "tone variation" means a variation of the trend with which said third parameter, for example power, associated with the single samples "S" varies; by way of example, in correspondence to a maximum of a function, the tone variation occurs when the third parameter, instead of further increasing, starts decreasing. A point in which this trend variation occurs is preferably an extreme of the interval "ΔK" to be determined. This tone variation substantially corresponds to the points of a curve obtained from said third parameters in which the derivative is equal to zero.

Preferably, the sign of variation "δ" of a parameter is established by the values of said third parameter, for example power, associated with the points close to the initial sample "S0", at a distance at least equal to "δ", as a function of the type of fundamental point searched. In case the type of fundamental point searched is the relative/absolute maximum point, then the sign of the variation of the first parameter or second parameter, such as for example current or voltage, must be such as to allow the analysis of the sample with a value of the third parameter that is greater than the value of the third parameter calculated for the initial sample "S0". In case the fundamental point searched is the relative/absolute minimum point, the sign of the variation "δ" of the first parameter and/or of the second parameter must be such as to identify samples, close the initial sample "S0", whose third parameter calculated has a value that is smaller than the one referring to the initial sample "S0".

Preferably, said variation "δ" is a multiple of the resolution with which samples "S" were collected for the respective parameters. This allows operators to reduce the effects of noise in curves acquired experimentally.

Preferably, the parameter that has changed is the same parameter used for the determination of the samples, for example voltage and/or current.

In the example shown in figures 5 and 6, this method is directly applied to the power-voltage graph of at least one power supply module, for example a photovoltaic module; moving one from one sample to be analyzed to the other, by increasing the voltage by a variation "δ", one moves along the curve, from a sample to the other, thus determining, in figure 5, the maximum point of the power-voltage curve of at least one power supply module. In the example of figure 6, in the power-voltage graph of at least one power supply module, for example a photovoltaic module, the aforesaid step allows operators to determine two maximum points, an absolute one and a relative one, and a relative minimum point, which is comprised between the two maximum points mentioned above.

The method according to the present invention allows operators to reduce the number of samples needed to characterize the critical points of a characteristic curve or function of a power supply module. The method according to the present invention allows operators to use, for example, three samples "S", preferably at least three samples, to characterize any fundamental or characteristic point of any characteristic curve of any power supply module. The characterization of these points, though, can be carried out by using any number of samples "S", without for this reason going beyond the scope of protection of the present invention.

Before moving on to the step of storing the samples obtained from the determination of intervals "ΔK", one should consider the possibility of errors in the calculation of these first intervals "ΔK", or the presence of areas that were not taken into account during the aforesaid steps, which, though, could contain samples provided with a quantity of information that is large enough to characterize the characteristic curve of said at least one power supply module in the best possible way.

In particular, there will be an attempt to further reduce the number of samples that will be stored in the following step, in particular to remove redundant or multiple sample intervals "ΔK" for each portion close to a critical or characteristic point of a characteristic curve. In the example of a voltage-current curve of any power supply module, there are sample intervals "ΔK" for each portion close to a curvature point or knee point.

In general, furthermore, there will be an attempt to identify the areas in which the sampling was not sufficient, as a function of the skip used to obtain samples "S". An insufficient sampling could be caused by a fault of the sampling circuit used to collect the samples and/or by errors in the A/D conversion, for example caused by a wrong configuration of the converter or by estimation errors.

An insufficient sampling can cause, in the regions in which the insufficient sampling has taken place, the presence of a variation, between two successive samples "S", of the comparison between said first number "N1" and said second number "N2", without this variation actually corresponding to a fundamental point of the characteristic curve. Hence, this variation is due to an error and not to the actual presence of a fundamental point of the characteristic curve.

The presence of one or more wrong variations, following the comparison, can cause the beginning of a step in which an interval "ΔK" is determined, for which no fundamental point of the curve will be identified, thus performing calculation operations that are useless of the method according to the present invention.

The control steps are carried out so as to avoid the useless use of a computer to perform calculations that are not essential for the execution of the method.

The method according to the present invention comprises a first control step to control said first intervals "ΔK", so as to check the type of fundamental point lying in said interval and to prevent said multiple and/or redundant first intervals "ΔK" from being stored.

Preferably, said first control step to control said first intervals "ΔK" comprises the following steps:
- for each first interval "ΔK", from at least one extreme of each interval, widening said first interval including at least three further samples "S";
- checking whether the first interval "ΔK" that has been widened at least partially coincides with another first interval, for example a neighboring one;
- checking whether the fundamental point lying in said other neighboring first interval is of the same type as the fundamental point of the first widened interval "ΔK".

More in detail, in case the widened interval does not fall within a neighboring interval "ΔK", this means that the fundamental point of the characteristic curve detected in the controlled interval "ΔK" was detected only once; namely, it was not detected more then once by other first intervals "ΔK"; hence, the first controlled interval "ΔK" is not a redundant interval.

On the other hand, in case the widened interval falls within another first interval, for example a neighboring one, one needs to check whether said other first interval contains a fundamental point of the curve of the same type.

For the purpose of the present invention, the term "point of the same type" indicates a point of the characteristic curve with the same mathematical properties, for example two maximum points, two minimum points, curvature points, inflection points, etc.

This check is aimed at determining whether two consecutive fundamental points are of the same type, namely, in the example of a voltage-current characteristic curve, whether after a curvature or knee point with a concavity facing downwards there is another curvature or knee point with a concavity facing downwards. If one determines that two fundamental points contained in two neighboring intervals are of the same type, this means that the interval is multiple or redundant. Redundancy takes place when the intersection between two neighboring intervals, concerning fundamental points of the same type, is not equal to zero.

Preferably, in case multiplicity or redundancy arises, the step of determining the interval "ΔK" is carried out again close to those samples "S", so as to eliminate any redundancy or multiplicity.

The first control step to control said first intervals "ΔK" preferably also comprises the following steps:
- checking whether, between two fundamental points of the same type, there is provided a fundamental point of an opposite type;
- checking whether there is a curvature point or knee point with a concavity facing upwards between the extreme of said first parameter, for example the short-circuit current "Isc", and the curvature point or knee point with a concavity facing downwards of the characteristic curve that is closest thereto;
- checking whether there is a curvature point or knee point with a concavity facing upwards between the extreme of said second parameter, for example the open-circuit voltage "Voc", and the curvature point or knee point with a concavity facing downwards of the characteristic curve that is closest thereto.

More in detail, in case there is no step of checking whether, between two fundamental points of the same type, there is provided a fundamental point of an opposite type, for example because between two curvature points with a concavity facing downwards there are provided more than one curvature points with a concavity facing upwards and vice versa, this means that the intervals associated with the two fundamental points of the same type were not determined correctly. Therefore, preferably, one should carry out again a step for the determination of an interval "ΔK" close to those samples.

The method according to the present invention preferably comprises a second control step, in which one checks for the presence of portions of the curve where an insufficient sampling has been performed.

A first step to check whether there are areas in which sapling might be insufficient involves determining the intervals (ΔV, ΔI) in which the corresponding third and/or fourth numbers "N3", "N4" have a value that is smaller than the respective mean value of said third numbers "N3" and of said fourth numbers "N4". Said third number "N3", said fourth number "N4" and the mean value among the third numbers "N3" and the fourth numbers "N4" of the respective first intervals and second intervals, for example concerning voltage and current, were calculated in the steps described above.

After having identified the intervals (ΔV, ΔI) in which the values of the third number "N3" and/or of the fourth number "N4" are smaller than the respective medium value, one checks whether, for two consecutive fundamental points identified in two different types, the variation of at least one parameter is greater than a predetermined threshold. Those intervals in which the variation of at least one parameter is greater than a predetermined threshold are intervals that were sampled in an insufficient manner. The pair of fundamental points analyzed must be chosen in such a way that the variation of at least one parameter that is greater than a predetermined threshold can be associated with a failure to detect a fundamental point of the characteristic curve, such as for example a curvature or knee point of a voltage-current curve of any power supply module.

In a possible application of the method according to the present invention, one could evaluate the current coverage, on the current-voltage curve of any power supply module, of the segments with a substantially constant current and/or the voltage coverage, on the current-voltage curve, of the segments with a substantially constant voltage or of each region close to a curvature or knee point. The storing of the samples of the low-density regions must be preferably performed only in those cases in which the coverage of a parameter, such as for example current or voltage, of the aforesaid segments exceeds at least one predetermined threshold.

For the purpose of the present invention, the term "evaluating the coverage of a parameter, such as for example current or voltage" means evaluating whether the sampling interval used is small enough not to generate scarcely sampled areas of the curve upon which the algorithm - namely the original curve whose samples have to be decimated - operates, with the methods known to a person skilled in the art.

Preferably, in a voltage-current curve, this threshold respectively corresponds to: for the voltage, a predetermined fraction or percentage of the open-circuit voltage "Voc" of said at least one module, for example 18%; for the current, a predetermined fraction or percentage of the short-circuit current "Isc" of said at least one module, for example 1/20.

Preferably, samples "S" comprised in the areas in which the sampling is insufficient and in which there presumably was a failure to detect at least one fundamental point, for example a knee point in a voltage-current curve, are stored so as to avoid the loss of information to characterize the characteristic curve. Preferably, in the scarcely sampled areas, all the samples comprised in these areas are stored. In particular, one stores all the samples "S" comprised in the intervals in which the third value "N3" and/or the fourth value "N4" associated therewith have a value that is smaller than the medium value.

Figure 7 shows a flowchart of the method according to the present invention in a preferred but non-limiting embodiment.

To sum up, the storing step to store the decimated samples involves the storing of the following samples:
- the samples comprised in the first intervals "ΔK", said interval having been subject to the first control step;
- the maximum values of said first parameter and of said second parameter and, in particular, in a voltage-current curve, the values of the short-circuit current "Isc" and of the open-circuit voltage "Voc";
- the samples comprised in the intervals (ΔV, ΔI) that, after the second control step, turned out to belong to areas of the sub-sampled characteristic and that belong to regions of the characteristic that were presumably affected by a failure to detect at least one fundamental point.

By way of example, compression ratio "CR" of the number of samples stored relative to the number of samples initially sampled can be determined by the following formula CR=(3*Nk+2)/Ns
wherein:
N_{K} - is the number of fundamental points of a characteristic curve;
N_{S} - is the number of initial samples "S" collected before the execution of the method according to the present invention.

The other addend in the numerator is due to the two additional samples that are stored, in particular the sample corresponding to the maximum values of the respective first and second parameter, and, in the case of a voltage-current curve, the short-circuit current "Isc" and the open-circuit voltage "Voc". The formula described above is valid if there are no areas of the curve that were sampled in an insufficient manner.

The method according to the present invention is especially designed to be implemented by means of a computer program.

The computer program, according to the present invention, is designed to be stored in memory means, preferably a non-volatile one, and can be executed by a computer.

Said computer could be the same processor or microcontroller comprised in the sampling system and/or in the control system of the system and/or in the system that manages the power supply module. In the specific case of the photovoltaic field, said electronic computer could be comprised in the reconfiguration system of the panels comprised in a photovoltaic system.

The computer program according to the present invention is configured to implement the method described above.

The method according to the present invention, by means of the algorithm described above, allows operators to only select the samples in the most critical points of the characteristic curve, thus eliminating the samples in the areas where there is no need to have a large number of samples to characterize the curve. In case of a current-voltage curve, the method according to the present invention allows operators to reduce the number of samples, for example, in the areas with a practically constant current and tension, where the number of samples can be reduced.

In particular, the method according to the present invention, when applied to a voltage-current curve, allows operators to store the samples close to the curvature points or knee points of the curve, both with a concavity facing upwards and with a concavity facing downwards. On the other hand, in a power-voltage curve, it allows operators to store the samples close to the maximum and minimum points, both absolute and relative. More in particular, the only samples of the voltage-current curve stored, besides the curvature or knee points, are the points of the short-circuit current and of the open-circuit voltage (Isc, Voc) and the possible samples comprised in the intervals (ΔI, ΔV) in which the sampling was insufficient.

Preferably, these samples must be stored when the intervals (ΔI, ΔV) belong to regions of the current-voltage characteristic curve delimited by pairs of different fundamental points having a current or voltage difference that exceeds a predetermined threshold.

The present invention allows operators to quickly control the power supply module, for example the photovoltaic system, during the operation, thus requiring a calculation ability of an electronic computer and an allocated memory that are much smaller compared to the methods used in the prior art. Furthermore, by reducing the number of samples stored for each single power supply module, one can obtain a general picture of a system comprising a plurality of strings of power supply modules, without the need to allocate a large quantity of memory and, furthermore, allowing operators to obtain the results needed in the entire system in short times, without the need to provide electronic computers with a great calculation ability. The reduction of the number of samples allows operators to remotely analyze the samples, without the need for high-performances communication lines, thus reducing the amount of time needed for the transmission of the samples themselves.

The decimation method and the computer program according to the present invention can be implemented and executed by an electronic computer with a low-cost data processing unit or processor or microcontroller, which can have reduced calculating abilities.

As already mentioned above, the method and the processing program can be performed and executed starting from simulations carried out by a calculator and not only starting from experimental data and measurements carried out in the field.

The method and the program according to the present invention can be implemented using samples stored both as floating-point format data and as integer fixed-point data.

In case integer fixed-point data are used, an approximation algorithm is used so as to avoid errors during the data calculation and processing steps. The approximation algorithm implemented does not affect the crucial aspects of the method and of the program according to the present invention, provided that this approximation algorithm does not introduce evident approximation errors.

The features of the single steps were indicated by way of example and decimation methods comprising steps that are substantially similar or carried out in a sequence other than the one described above should be considered as part of the scope of protection of the present invention.

The method according to the present invention basically allows operators to sample, with a very high resolution, any characteristic curve of any power supply module, though offering a number of samples actually stored in memory means that is significantly smaller.

The method and the computer program described above can be equally applied to different types of power supply modules, such as for example photovoltaic modules, battery modules or fuel cells.

The method according to the present invention can be equally applied to any characteristic curve of any power supply module, without for this reason going beyond the scope of protection of the present patent application.

Said first and second parameter can be of any kind, selected as a function of the characteristic curve for which one wants to reduce the number of samples needed for the identification.

In the specific photovoltaic field, the reduction of the number of samples needed to identify a characteristic curve of a photovoltaic module allows operators to obtain an advantage in terms of speed in determining the optimal configuration of the system, so as to obtain the maximum power production of the system itself.

## Claims

1. Method to decimate or reduce the number of samples (S) of at least one parameter that are necessary to identify at least one characteristic curve of at least one power supply module, said method being based on a series of samples (S) of at least a first parameter and a second parameter, obtained from measurements or simulations performed on said at least one power supply module;
said module is adapted to operate in:
• a field of a first characteristic parameter of said module;
• a field of a second characteristic parameter of said module;
said characteristic curve is defined at least by said first parameter and by said second parameter;
said method is **characterized in that** it comprises the following steps:
• dividing the field of a first parameter and the field of a second parameter into a plurality of intervals, first intervals (ΔI) and second intervals respectively (ΔV), with an assigned range;
• determining, for each second interval (ΔV) of said second parameter, a first number (N1) of first intervals (ΔI) of said first parameter covered by the samples (S) comprised in the single second interval (ΔV);
• determining, for each first interval (ΔI) of said second parameter, a second number (N2) of second intervals (ΔV) of said second parameter covered by the samples (S) comprised in the single first interval (ΔI);
• for each single sample (S), comparing the corresponding first number (N1) and the corresponding second number (N2) associated with the respective intervals (ΔV; ΔI) in which the sample (S) lies;
• identifying one or more samples (S), for which the comparison between the corresponding first number (N1) and the corresponding second number (N2) has a variation relative to the previous sample;
• for each sample identified in the previous step, starting from that sample, determining a first sample interval (ΔK) wherein at least one fundamental point of the characteristic curve lies;
• storing in a memory medium only the samples (S) comprised in each first value interval (ΔK) determined in the previous step.

2. Method according to claim 1, wherein said first parameter is the current and said second parameter is the voltage and the module is adapted to operate in:
• a current field ranging from 0A to the value of the short-circuit current (Isc) at the ends of said at least one module;
• a voltage field ranging from 0V to the open-circuit voltage value (Voc) at the ends of said at least one module.

3. Method according to claim 1, wherein, during the step in which, for each single sample (S), said first number (N1) and said second number (N2) are compared, said comparison step comprises:
- a first normalization step, in which said first number (N1) and said second number (N2) are normalized relative to the maximum value taken on by the respective first and second number (N1, N2) among all the respective intervals (ΔV; ΔI), and
- a second step, in which there is a comparison between the values of said first and second normalized numbers (N1', N2').

4. Method according to any of the previous claims, wherein, furthermore, the subsequent samples are stored:
• the value of the limit of the field of said first parameter;
• the value of the limit of the field of said second parameter.

5. Method according to any of the previous claims, wherein the comparison step comprises an intermediate multiplication step, in which said first numbers (N1) and said second numbers (N2) are multiplied by a respective known scale factor.

6. Method according to any of the previous claims, wherein the following further steps are performed:
• determining, for each second interval (ΔV) of said second parameter, a third number (N3) of samples (S) comprised in the single second interval (ΔV);
• determining, for each first interval (ΔI) of said first parameter, a fourth number (N4) of samples (S) comprised in the single first interval (ΔI);
• determining the mean value of said third numbers (N3) and the mean value of said fourth numbers (N4) comprised in the intervals (ΔV; ΔI);
• determining the first intervals and the second intervals, of said first parameter and of said second parameter respectively, in which the number (N3 and/or N4) of samples is smaller than the mean value.

7. Method according to any of the previous claims, wherein, during the step of identifying one or more samples (S), for which the comparison between said first number (N1) and said second number (N2) has a variation, said variation corresponds to a sign change of a difference between said first normalized number (N1') and said second normalized number (N2') relative to the previous sample.

8. Method according to claim 1, wherein, during the step in which, for each sample identified in the previous step, at least one sample is identified, in order to determine the extension of a first interval (ΔK), the following steps are provided:
• starting from an initial sample (SO) determined in the previous step, calculating the value of a third parameter referring to said initial sample (SO) and temporarily storing said value of the third parameter;
• moving on to a first subsequent sample (S1), consequence of a variation (δ) of at least one parameter between said first parameter or said second parameter,
• calculating the value of said third parameter associated with said first subsequent sample (S1);
• comparing the value of said third parameter referring to said first subsequent sample (S1) with the value of the third parameter calculated for said initial sample (SO);
• moving on to a second subsequent sample (S2), consequence of a variation (δ) of at least one parameter;
• calculating the value of said third parameter associated with said second subsequent sample (S2) and comparing said value of said third parameter with the value of said third parameter calculated for at least one sample examined previously (SO,S1);
• continuing to vary the sample until the value of the third parameter calculated for a generic subsequent sample (Sn) has a tone variation relative to the tone detected for the values of the third parameter calculated for at least two samples examined previously (Sn-2 and Sn-1).

9. Method according to claim 8, wherein, starting from an initial sample (SO), there is provided a sequence of steps to determine said first interval (ΔK), in which a variation (δ) with a positive value is initially performed, and a following sequence of steps, in which a variation (δ) with a negative signal is provided, so as to determine both the region in which to look for the fundamental point and the sign of the variation (δ) of at least one parameter with which to look for the fundamental point.

10. Method according to any of the previous claims, wherein there is provided a first control step to control said first intervals (ΔK), so as to check the type of fundamental point lying in said interval and to prevent said multiple and/or redundant first intervals (ΔK) from being stored.

11. Method according to claim 10, wherein said first control step to control said first intervals (ΔK) comprises the following steps:
- for each first interval (ΔK), from at least one limit of each interval, widening said first interval including at least three further samples (S);
- checking whether the first interval that has been widened coincides, at least partially, with another neighboring first interval (ΔK);
- checking whether the fundamental point lying in said other neighboring first interval (ΔK) is of the same type as the fundamental point of the widened interval.

12. Method according to claim 10 or 11, wherein said first control step to control said first intervals (ΔK) comprises the following steps:
- checking whether, between two fundamental points of the same type, there is provided a fundamental point of the opposite type;
- checking whether there is a curvature point or a knee point with a concavity facing upwards between the limit of said first parameter (Isc) and the curvature point with a concavity facing downwards of the characteristic curve that is closest thereto;
- checking whether there is a curvature point with a concavity facing upwards between the limit of said second parameter (Voc) and the curvature point with a concavity facing downwards of the curve that is closest thereto.

13. Method according to any of the previous claims, wherein there is provided a second control step, in which one checks for the presence of portions of the curve where an insufficient sampling has been performed.

14. Method according to claim 6 and 13, wherein one checks for the presence of portions of the curve where an insufficient sampling has been performed by determining the intervals (ΔV, ΔI) in which the corresponding third value (N3) and/or the fourth value (N4) associated therewith has a value that is lower than the respective mean value of said third numbers (N3) and of said fourth numbers (N4).

15. Method according to claim 14, wherein one stores all the samples (S) comprised in the intervals in which the third value (N3) and/or the fourth value (N4) associated therewith has a value that is lower than the mean value.

16. Method according to claim 13 or 14 or 15, wherein:
- one checks whether, for two consecutive fundamental points identified in two different types, the variation of at least one parameter is higher than a predetermined threshold.

17. Method according to claims 2 and 16, wherein said threshold corresponds to:
for the voltage, a predetermined fraction or percentage of the open-circuit voltage (Voc) of said at least one power supply module,
for the current, a predetermined fraction or percentage of the short-circuit current (Isc) of said at least one power supply module.

18. Computer program, which is adapted to be stored in a memory medium, preferably a non-volatile one, and can be executed by a computer;
said program is configured to implement the method according to any of the method claims from 1 to 17.
